# DEMANDE DE BREVET EUROPEEN

(11) **EP 3 742 492 A1**
(43) Date de publication de la demande: **25.11.2020**
(21) Numéro de dépôt: 20186121.8
(22) Date de dépôt: 16.11.2018
(51) Int. Cl.: H01L 27/30, H01L 51/42, H01L 27/146

(54) **CAPTEUR D'IMAGE**

(30) Priorité: 21.12.2017 FR 1762783
(62) Demande divisionnaire de: 18825745.5
(71) Demandeur: ISORG, 38000 Grenoble (FR)
(72) Inventeur: BOUTHINON, Benjamin, 38000 GRENOBLE (FR); SARACCO, Emeline, 38000 GRENOBLE (FR); GOMEZ, Jean-Yves, 38000 GRENOBLE (FR); DHEZ, Olivier, 38000 GRENOBLE (FR)
(74) Mandataire: Cabinet Beaumont

(57) **Abrégé**

L'invention concerne un capteur d'image (10) comportant une matrice de circuits de lecture en technologie non organique et des photodiodes (OPD) en matériaux organiques, dans lequel chaque photodiode (OPD) comporte une première électrode (25) ayant la taille d'un pixel ou sous-pixel du circuit de lecture associé.

## Description

La présente demande de brevet revendique la priorité de la demande de brevet français 17/62783 qui sera considérée comme faisant partie intégrante de la présente description.

### Domaine

La présente description concerne un capteur d'image ou imageur électronique. La présente description concerne plus particulièrement les dispositifs comprenant un photodétecteur organique.

### État de l'art antérieur

Les capteurs d'image sont utilisés dans de nombreux domaines, en particulier dans les dispositifs électroniques grâce à leur miniaturisation. On retrouve des capteurs d'image que ce soit dans des applications d'interface homme-machine ou dans des applications de prise d'image.

La présente description concerne plus particulièrement les capteurs d'image formés à partir d'un photodétecteur en matériaux organiques.

Un exemple de photodétecteur en matériaux organiques est décrit dans le document US-B-9,417,731.

Le document US 2015/060775 décrit une photodiode organique avec une double couche de blocage d'électrons.

Le document US 2009/090903 décrit un capteur d'image CMOS ayant des dérivés de thiophène.

Le document WO 99/39372 décrit des capteurs d'image réalisés à partir de semiconducteurs organiques.

### Résumé

Un mode de réalisation pallie tout ou partie des inconvénients des capteurs d'image intégrant un photodétecteur en matériaux organiques.

Un mode de réalisation propose une solution évitant le recours à des technologies organiques pour l'ensemble du capteur d'image.

Ainsi, un mode de réalisation prévoit un capteur d'image comportant une matrice de circuits de lecture en technologie non organique et des photodiodes en matériaux organiques, dans lequel chaque photodiode comporte une première électrode ayant la taille d'un pixel ou sous-pixel du circuit de lecture associé.

Selon un mode de réalisation, les circuits de lecture sont en technologie CMOS.

Selon un mode de réalisation, chaque photodiode est séparée des photodiodes voisines par des espaceurs en matériau électriquement isolant.

Selon un mode de réalisation, les espaceurs sont en matériau transparent.

Selon un mode de réalisation, les espaceurs sont opaques à la lumière.

Selon un mode de réalisation, les espaceurs absorbent la lumière.

Selon un mode de réalisation, la première électrode est connectée à une grille d'un premier transistor du circuit de lecture.

Selon un mode de réalisation, la première électrode est reliée à une grille d'un premier transistor du circuit de lecture par l'intermédiaire d'un ou plusieurs transistors additionnels.

Selon un mode de réalisation, une deuxième électrode des photodiodes est commune à plusieurs circuits de lecture.

Selon un mode de réalisation, la deuxième électrode est formée d'une couche conductrice transparente organique.

Selon un mode de réalisation, chaque pixel ou sous-pixel s'inscrit dans un carré d'environ 50 µm de côté.

Selon un mode de réalisation, les pixels ou sous-pixels sont latéralement espacés de moins de 5 µm.

Selon un mode de réalisation, la deuxième électrode est recouverte d'une couche translucide de protection.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en perspective représentant de façon schématique un mode de réalisation d'un capteur d'image ;
la figure 2 est une vue en coupe d'un mode de réalisation d'un capteur d'image ;
la figure 3 est une vue de dessus schématique du capteur d'image de la figure 2 ;
la figure 4 représente le schéma électrique simplifié d'un circuit de lecture CMOS à trois transistors ; et
la figure 5 illustre, de façon très schématique, un exemple de couches d'une photodiode organique.

### Description détaillée

De mêmes éléments ont été désignés par de mêmes références aux différentes figures.

Par souci de clarté, seules les étapes et éléments utiles à la compréhension des modes de réalisation qui vont être décrits ont été représentés et seront détaillés. En particulier, le fonctionnement du capteur d'image n'a pas été détaillé, les modes de réalisation décrits étant compatibles avec les capteurs usuels, qu'il s'agisse de purs capteurs d'image ou de capteurs intégrant un écran d'affichage. De plus, les autres constituants du dispositif électronique intégrant le capteur d'image n'ont pas non plus été détaillés, les modes de réalisation décrits étant compatibles avec les autres constituants usuels des dispositifs électroniques à application de capteur d'image.

Sauf précision contraire, lorsque l'on fait référence à deux éléments connectés entre eux, cela signifie directement connectés sans élément intermédiaire autre que des conducteurs, et lorsque l'on fait référence à deux éléments reliés ou couplés entre eux, cela signifie que ces deux éléments peuvent être directement reliés (connectés) ou reliés par l'intermédiaire d'un ou plusieurs autres éléments.

Dans la description qui suit, lorsque l'on fait référence aux termes « approximativement », « environ » et « de l'ordre de », cela signifie à 10 % près, de préférence à 5 % près.

Par ailleurs, lorsque l'on fait référence à des qualificatifs de position absolue, tels que les termes "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence, sauf précision contraire, à l'orientation des figures.

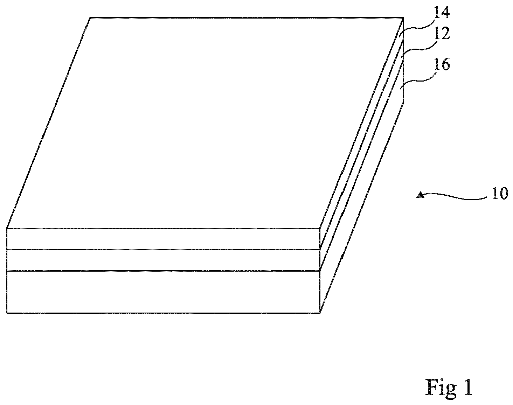

La figure 1 est une vue en perspective représentant de façon schématique un exemple de capteur d'image 10.

Le capteur 10 comprend un ensemble de capteurs de photons, ou photodétecteurs 12, par exemple une matrice de photodétecteurs. Dans cet exemple, les photodétecteurs 12 sont disposés sur une surface plane. Des modes de réalisation pourront toutefois être prévus dans lesquels les photodétecteurs 12 sont disposés sur une surface non plane. La matrice de photodétecteurs 12 peut être surmontée d'un revêtement de protection transparent ou translucide 14, par exemple une plaque de verre, un revêtement en plastique, un dépôt en utilisant une technologie de dépôts successifs de couches monoatomiques ou un dépôt d'une ou plusieurs autres couches de passivation. La matrice de photodétecteurs 12 est associée à une matrice de circuits de lecture 16, de mesure des signaux captés par les photodétecteurs. Par circuit de lecture, on entend un ensemble de transistors de lecture, d'adressage et de commande du pixel ou sous-pixel défini par le photodétecteur correspondant. Ce circuit peut être intégré sur la même surface de silicium que la matrice ou réseau de pixels, ou être un circuit ou un ensemble de circuits électroniques associés au réseau de pixels.

Selon les photodétecteurs utilisés dans la matrice 12 et la présence éventuelle de filtres, le dispositif 10 est adapté à capter des ombres, des images infrarouges, des images noir et blanc, des images couleur (RGB), etc.

Le capteur d'image 10 peut en outre être associé à un écran d'affichage, de façon à réaliser une interface interactive.

Les modes de réalisation décrits par la suite s'appliquent à toutes ces applications, y compris combinées.

Les capteurs organiques sont généralement agencés avec des premières électrodes en bandes dans une première direction, des secondes électrodes en bandes dans une deuxième direction, et avec le matériau actif entre les deux. Chaque pixel du capteur comporte un élément photodétecteur en matériaux organiques à l'intersection entre les bandes d'électrodes. Les circuits d'interprétation des signaux aux bornes des électrodes sont généralement externes au plan de la matrice de pixels.

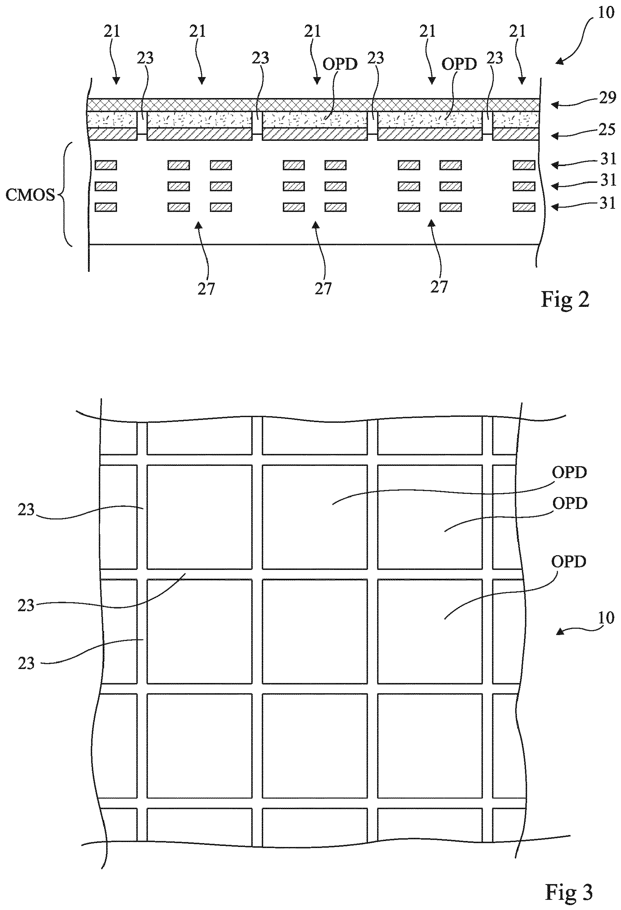

La figure 2 est une vue partielle en coupe d'un mode de réalisation d'un capteur d'image 10.

La figure 3 est une vue de dessus schématique du capteur d'image de la figure 2, au niveau des éléments organiques 10.

Selon les modes de réalisation décrits, on prévoit de réaliser un capteur d'image en associant des photodétecteurs ou photodiodes organiques OPD et des circuits de lecture non organiques, en technologie CMOS sur substrat semiconducteur. Plus précisément, on prévoit de superposer un réseau de photodiodes organiques OPD à un réseau de circuits de lecture CMOS, ou pixels CMOS, chaque photodiode constituant l'élément de détection d'un pixel 21 ou d'un sous-pixel du capteur d'image.

Tout ce qui sera décrit par la suite en relation avec un pixel s'entend plus généralement d'un sous-pixel, en particulier pour un capteur d'image couleur dont chaque pixel est généralement constitué de quatre sous-pixels.

Comme l'illustrent les figures 2 et 3, chaque photodiode est séparée des photodiodes voisines par un espaceur 23. Ainsi, les espaceurs 23 délimitent les zones actives de photodiodes afin de les isoler électriquement les unes des autres. Les espaceurs 23 sont donc en un matériau électriquement isolant.

De plus, au moins une des couches d'électrodes (typiquement la couche de cathode 25) est structurée (pixélisée) de sorte à définir une cathode d'une photodiode à l'aplomb d'un circuit CMOS 27 du pixel correspondant. L'autre électrode (l'anode 29) peut également être pixélisée, mais peut en variante être en bandes. Dans le cas où l'anode est pixélisée, les électrodes d'anode sont toutefois interconnectées au moins dans une première direction afin de permettre leur polarisation.

Les circuits ou pixels CMOS sont représentés de façon très schématique, leur réalisation étant usuelle et les modes de réalisation décrits étant compatibles avec les circuits CMOS usuels, réalisés sur substrat silicium ou autre, à partir de matériaux non organiques, semiconducteurs et conducteurs. On a symbolisé en figure 2 les niveaux 31 d'interconnexion métalliques des transistors.

Selon un mode de réalisation, les espaceurs 23 sont en matériau transparent.

Selon un autre mode de réalisation, les espaceurs 23 sont, de préférence, en un matériau opaque et/ou absorbant la lumière. Cela permet de tirer profit de la granularité d'un imageur CMOS dont les pixels sont proches les uns des autres, tout en évitant les fuites de lumière d'un pixel au pixel voisin. En effet, les pixels d'un capteur CMOS sur silicium sont, à titre d'exemple, d'environ 50 pm de côté et sont distants les uns des autres de moins de 5 pm. Or, l'épaisseur des couches actives d'une photodiode organique est généralement de quelques µm et est donc du même ordre de grandeur que l'intervalle entre deux pixels. Rendre les espaceurs opaques ou absorbants évite les interférences lumineuses entre pixels et améliore donc la définition du capteur d'image.

A titre d'exemple particulier de réalisation, les espaceurs 23 sont en résine, en résine à base fluorée ou en résine à base de polyimide ou de parylène ou autres matériaux isolants.

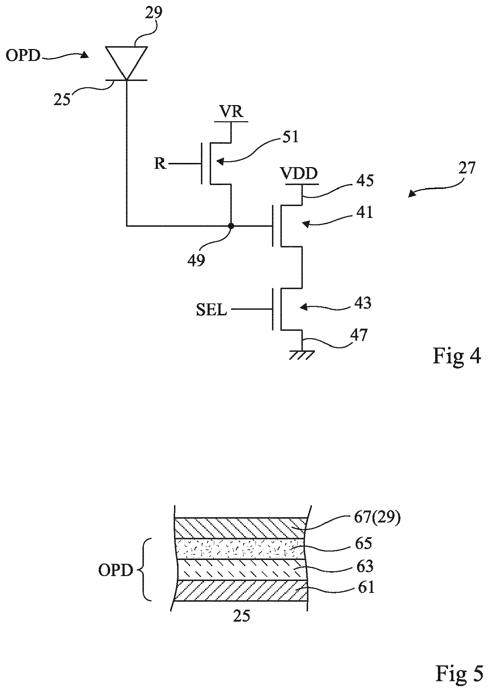

La figure 4 représente le schéma électrique simplifié d'un circuit de lecture ou pixel CMOS 27 à trois transistors, associé à une photodiode organique OPD.

Le circuit de lecture 27 comporte un transistor MOS de détection 41, en série avec un transistor MOS de sélection 43, entre deux bornes 45 et 47 d'application d'une tension continue VDD. La grille du transistor 43 est destinée à recevoir un signal SEL de sélection du pixel. La grille 49 du transistor 41 définit une borne d'entrée du circuit CMOS. La grille 49 est reliée, par un transistor MOS 51 de réinitialisation, à une borne d'application d'un potentiel VR de réinitialisation. La grille du transistor 51 est destinée à recevoir un signal R de commande en réinitialisation du pixel (de décharge de la grille 49 du transistor de détection 41).

La grille 49 du transistor 41 est reliée à l'électrode de cathode 25 de la photodiode organique OPD du pixel considéré. L'électrode d'anode 29 de la photodiode OPD est reliée à un potentiel fixe (non représenté) ou à la masse, mais peut être sur commande portée à différents potentiels.

Le fonctionnement d'un circuit de lecture CMOS est connu et n'est pas modifié par les modes de réalisation décrits. Par ailleurs, on pourra utiliser des circuits de lecture CMOS à quatre transistors (4T) dans lesquels un transistor de transfert est intercalé entre la cathode 25 de la photodiode OPD et la grille 49 du transistor de détection 41, voire des circuits de lecture CMOS à plus de quatre transistors avec plusieurs transistors additionnels entre la cathode 25 et la grille du transistor 49.

La figure 5 illustre de façon très schématique un exemple de couches d'une photodiode organique.

Dans cet exemple, chaque photodiode organique OPD comprend un empilement, dans l'ordre à partir d'une électrode 25 de cathode connectée au circuit CMOS :
une couche 61 en un polymère semiconducteur organique très dopé (couche donneuse de trous) ;
une couche 63 en un polymère semiconducteur organique, par exemple le poly(3-hexylthiophène) ou poly(3-hexylthiophène-2,5-diyl) (semiconducteur de type P), connu sous la dénomination P3HT, ou le [6,6]-phényl-C61-butanoate de méthyle (semiconducteur de type N), connu sous la dénomination PCBM ;
une couche 65 en un polymère semiconducteur organique transparent très dopé (couche donneuse d'électrons), par exemple un polymère connu sous la dénomination Pedot-PSS, qui est un mélange de poly(3,4)-éthylènedioxythiophène et de polystyrène sulfonate de sodium ; et
une couche transparente 67, par exemple en oxyde d'indium-étain (ITO, de l'anglais Indium Tin Oxyde), en Pedot-PSS, ou en matériau organique conducteur transparent, par exemple à base de nanofils conducteurs, de graphène, ou de nano particules conductrices ou semiconductrices.

L'électrode de cathode 25 est, par exemple, en aluminium, en argent, en ITO, en Molybdène Tantale (MoTa), en tungstène, en chrome, en Pedot-PSS ou autre métal ou matériau organique conducteur ou semiconducteur.

Les couches 61 et 65 ont pour rôle d'adapter le travail de sortie entre la couche active 63 s'apparentant à une jonction PN et les électrodes de cathode et d'anode respectivement.

Par conséquent, selon le travail de sortie des différentes couches, la couche 67 ou la couche 65 constitue le cas échéant directement l'anode 29.

De façon similaire, en fonction du travail de sortie de la couche 25, la couche 61 peut être omise.

Des techniques de fabrication de photodiodes organiques sont décrites, par exemple, dans le document US-B-9,417,731.

Un avantage des modes de réalisation décrits est qu'ils rendent possible la combinaison des technologies de fabrication de circuits de lecture semiconducteurs CMOS sur silicium ou autre substrat semiconducteur non organique, et des technologies de fabrication de photodiodes organiques.

Un autre avantage est que cela rend possible la réalisation d'un capteur infrarouge (autour de 1400 nm) ou proche infrarouge (autour de 940 nm), tirant profit des longueurs d'ondes admissibles pour les photodiodes organiques et de la résolution des capteurs CMOS non organiques.

Un autre avantage des modes de réalisation décrits est que la pixellisation réalisée est compatible avec l'adjonction de microlentilles côté anode.

Parmi les applications d'un capteur d'image ou imageur tel que décrit, on notera les dispositifs de suivi du regard, la reconnaissance faciale, les capteurs d'empreintes digitales, les dispositifs de vision nocturne, les caméras, etc.

Divers modes de réalisation ont été décrits. Diverses modifications apparaîtront à l'homme de l'art. En particulier, le choix des matériaux constitutifs des couches 61, 63 et 65 dépend de l'application et notamment des longueurs d'ondes que l'on souhaite détecter. Par ailleurs, on pourra prévoir un matériau réfléchissant pour la cathode 25 afin d'améliorer la sensibilité des photodiodes. On pourra notamment prévoir de l'or ou un alliage de tungstène et molybdène. En outre, la mise en oeuvre pratique des modes de réalisation qui ont été décrits est à la portée de l'homme du métier à partir des indications fonctionnelles données ci-dessus.

## Revendications

1. Capteur d'image (10) comportant une matrice de circuits de lecture en technologie non organique et des photodiodes (OPD) en matériaux organiques, dans lequel chaque photodiode (OPD) comporte une première électrode (25) ayant la taille d'un pixel ou sous-pixel du circuit de lecture associé.

2. Capteur selon la revendication 1, dans lequel les circuits de lecture sont en technologie CMOS.

3. Capteur selon la revendication 1 ou 2, dans lequel chaque photodiode (OPD) est séparée des photodiodes voisines par des espaceurs (23) en matériau électriquement isolant.

4. Capteur selon la revendication 3, dans lequel les espaceurs (23) sont en matériau transparent.

5. Capteur selon la revendication 3, dans lequel les espaceurs (23) sont opaques à la lumière.

6. Capteur selon la revendication 3 ou 5, dans lequel les espaceurs (23) absorbent la lumière.

7. Capteur selon l'une quelconque des revendications 1 à 6, dans lequel la première électrode (25) est connectée à une grille (49) d'un premier transistor (41) du circuit de lecture (27) .

8. Capteur selon l'une quelconque des revendications 1 à 6, dans lequel la première électrode est reliée à une grille (49) d'un premier transistor (41) du circuit de lecture (27) par l'intermédiaire d'un ou plusieurs transistors additionnels.

9. Capteur selon l'une quelconque des revendications 1 à 8, dans lequel une deuxième électrode (29) des photodiodes (OPD) est commune à plusieurs circuits de lecture (27).

10. Capteur selon la revendication 9, dans lequel la deuxième électrode est recouverte d'une couche translucide (14) de protection.

11. Capteur selon la revendication 9 ou 10, dans lequel la deuxième électrode (29) est formée d'une couche conductrice transparente organique.

12. Capteur selon l'une quelconque des revendications 1 à 11, dans lequel chaque pixel ou sous-pixel s'inscrit dans un carré de moins de 50 µm de côté.

13. Capteur selon l'une quelconque des revendications 1 à 12, dans lequel les pixels ou sous-pixels sont latéralement espacés de moins de 5 µm.
